# EUROPEAN PATENT APPLICATION

(11) **EP 2 180 086 A1**
(43) Date of publication of application: **28.04.2010**
(21) Application number: 09252478.4
(22) Date of filing: 26.10.2009
(51) Int. Cl.: C23C 28/00, C23C 14/02, C23C 14/30, C23C 14/32, C23C 14/58

(54) **Method for use in a coating process**

(30) Priority: 24.10.2008 US 257581
(71) Applicant: United Technologies Corporation, Hartford, CT 06101 (US)
(72) Inventor: Neal, James W., Ellington, CT 06029 (US); Maloney, Michael J., Marlborough, CT 06447 (US); Litton, David A., Rocky Hill, CT 06067 (US); Hammond, Clifford A., East Hampton Connecticut 06424 (US); Zimmerman, Benjamin J., Enfield Connecticut 06082 (US)
(74) Representative: Leckey, David Herbert

(57) **Abstract**

A method for use in a coating process includes depositing a ceramic coating on a bond coat that is disposed on a substrate. Prior to depositing the ceramic coating, a desired surface roughness R_{z} is established to control a bonding strength between the bond coat and the ceramic coating.

## Description

### BACKGROUND OF THE INVENTION

This disclosure relates to a coating process and, more particularly, to a method for use in a coating process to increase a bonding strength of a ceramic coating.

Airfoils and other articles in turbine engines typically operate in relatively harsh environments. For instance, an airfoil may operate under high temperatures, corrosive conditions, and a variety of different stresses. The article may include a coating for protection against the environmental conditions. For example, the coating may be a ceramic coating. However, one problem with using ceramic coatings is that the ceramic coating may detach from the underlying substrate (i.e., spall) during operation due to elevated temperatures, internal stresses, or other factors. Loss of the ceramic coating may compromise the durability of the article and/or decrease operational efficiency of the article.

### SUMMARY OF THE INVENTION

A disclosed method for use in a coating process includes depositing a ceramic coating on a bond coat that is disposed on a substrate. A desired surface roughness Rz of the bond coat is established prior to depositing the ceramic coating to control a bonding strength between the bond coat and the ceramic coating. For example, the desired surface roughness Rz may be an average of surface heights over unit lengths of the bond coat, where each of the surface heights extend between a highest surface peak and a lowest surface valley within one of the unit lengths.

In one example, the ceramic coating may include gadolinia stabilized zirconia, the bond coat may include a metal-chromium-aluminum-yttrium layer, where the metal includes at least one of nickel, cobalt, or iron, and the substrate may include a nickel or cobalt alloy.

In one example, the desired surface roughness Rz may be established by peening the bond coat using a first peening intensity followed by peening the bond coat using a second peening intensity that is lower than the first peening intensity.

### BRIEF DESCRIPTION OF THE DRAWINGS

The various features and advantages of the disclosed examples will become apparent to those skilled in the art from the following detailed description. The drawings that accompany the detailed description can be briefly described as follows.

Figure 1 illustrates an example method for use in a coating process.

Figure 2 illustrates another example method for use in a coating process.

### DETAILED DESCRIPTION OF THE PREFERRED EMBODIMENT

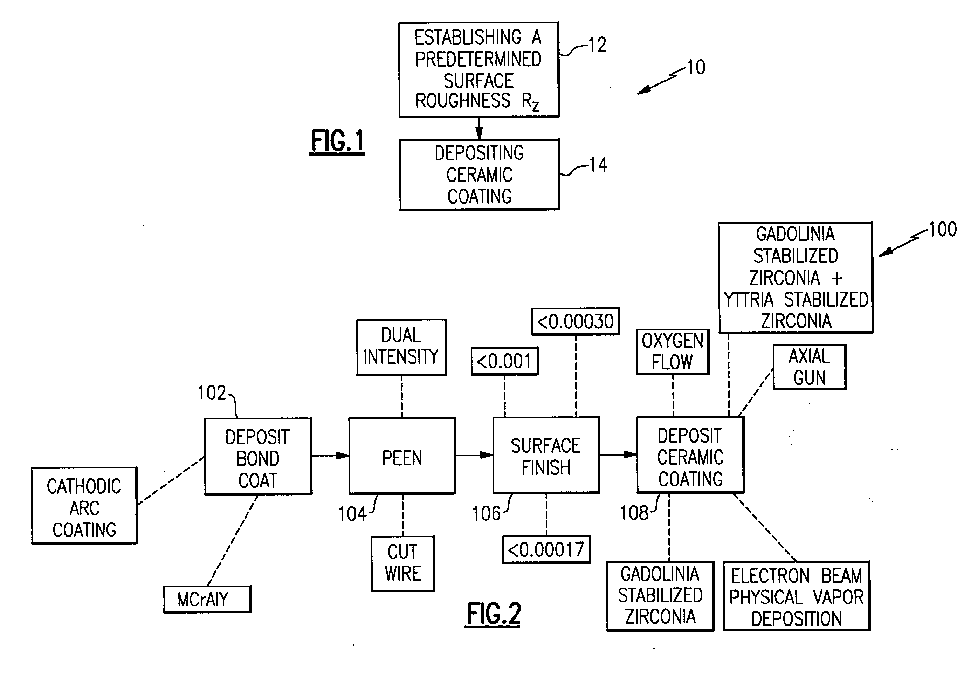

Figure 1 illustrates an example method 10 for use in a coating process. For instance, the coating process may include depositing a ceramic coating 14 on a substrate of an article. The article may be any type of article that would benefit from having the ceramic coating, such as a gas turbine engine component (e.g., airfoil) for use within a gas turbine engine. As will be described, the example method 10 may be used to enhance bonding strength between the ceramic coating and an underlying bond coat disposed on the substrate.

The disclosed examples will be described with reference to a gas turbine engine component; however, it is to be understood that the examples may apply to other types of articles and other compositions. The substrate of the gas turbine engine component may be comprised of a superalloy material, such as a nickel alloy. The bond coat may include a metal-chromium-aluminum-yttrium layer ("MCrAIY") that facilitates bonding between the substrate and the ceramic coating. The metal of the bond coat may include at least one of nickel, cobalt, or iron. A suitable deposition technique may be used to deposit the bond coat onto the substrate. For example, the bond coat may be deposited using a known physical vapor deposition method, such as cathodic arc coating. Cathodic arc coating provides the benefit of depositing a relatively dense layer of the bond coat with limited oxidation (e.g., oxidation may cause an increase in residual stress).

The ceramic coating may include gadolinia stabilized zirconia deposited on the metal-chromium-aluminum-yttrium bond coat. The gadolinia stabilized zirconia may be comprised of about 59wt% gadolinia and a balance of the zirconia. The ceramic coating may also include a combination of the gadolinia stabilized zirconia and yttria stabilized zirconia (e.g., layers or intermixed). The term "about" as used in this description relative to compositions or other values refers to possible variation in the given value, such as normally accepted variations or tolerances in the art.

Prior to depositing the ceramic coating 14 on the bond coat of the substrate, the method 10 includes establishing a desired surface roughness Rz 12 to facilitate forming a strong bond between the bond coat and the ceramic coating. The surface roughness Rz of the bond coat inversely correlates to the bonding strength between the bond coat and the ceramic coating. Other surface characteristics such as surface roughness RA do not exhibit any significant correlation to bonding strength or durability. A relatively low surface roughness Rz provides a relatively high bonding strength, and a relatively high surface roughness Rz provides a relatively low bonding strength. For example, a relatively low surface roughness Rz increases bonding strength by permitting a more uniform layer of the ceramic coating to be applied, thereby increasing fracture toughness and decreasing residual stresses. Therefore, establishing the desired surface roughness Rz 12 permits control over the bonding strength and provides the benefit of increasing the durability and spallation resistance of the ceramic coating.

For a given set of deposition parameters, yttria stabilized zirconia generally forms a stronger bond with the bond coat than gadolinia stabilized zirconia. However, establishing the desired surface roughness Rz 12 prior to depositing the gadolinia stabilized zirconia using the method 10 facilitates increasing the bonding strength of the gadolinia stabilized zirconia to be equal to or greater than the bonding strength of yttria stabilized zirconia. Therefore, the disclosed method 10 enables the use of gadolinia stabilized zirconia in addition to or as a replacement of yttria stabilized zirconia.

The surface roughness Rz may be represented by an average of surface heights over unit lengths of the bond coat, where each of the surface heights extends between a highest surface peak and a lowest surface valley within one of the unit lengths. For instance, surface roughness Rz may be determined using contact or non-contact methods. Contact methods may include dragging a measurement probe across the surface of the bond coat using a profilometer. Non-contact methods may include interferometry, confocal microscopy, or electron microscopy, for example. Given this description, one of ordinary skill in the art will recognize other suitable measurement methods to meet their particular needs.

Figure 2 schematically illustrates another example method 100 that is similar to the method 10 but includes additional options that may be used in the coating process. The method 100 includes depositing the bond coat 102, peening the bond coat 104, surface finishing the bond coat 106, and depositing the ceramic coating 108. For example, peening the bond coat 104 and surface finishing the bond coat 106 may be used to establish a desired surface roughness Rz. Depositing the bond coat 102 may include depositing MCrAIY using cathodic arc coating technique as described above.

Peening the bond coat 104 may include using a cut wire peening media to facilitate establishing the desired surface roughness Rz and densify the bond coat. For instance, the cut wire may be steel wire. The peening may be dual intensity peening that utilizes a first peening intensity followed by a second peening intensity that is less than the first peening intensity. Peening intensity may be determined using known techniques, such as by determining an Almen intensity. Using the dual intensity peening provides the benefit of densifying the bond coat using the higher intensity and removing the highest surface peaks of the bond coat using the lower intensity to achieve a relatively low surface roughness Rz.

After peening the bond coat 104, surface finishing may be used to further smooth the surface or to remove surface oxides and residual foreign substances from the peening. For instance, the surface finishing may include vibration milling or grit blasting the bond coat.

The desired surface roughness Rz that is established may vary depending upon the desired bonding strength, durability, or spallation resistance. In one example, the desired surface roughness Rz is less than about 0.0003 inches (0.00762 millimeters). If a higher bonding strength is desired, the desired surface roughness Rz may be less than about 0.001 inches (0.0254 millimeters). For an even greater bonding strength, the desired surface roughness Rz may be about 0.00017 inches (0.004318 millimeters).

After establishing the desired surface roughness Rz, the ceramic coating is deposited on the bond coat. The ceramic coating may include the gadolinia stabilized zirconia or a combination of gadolinia stabilized zirconia and yttria stabilized zirconia as described above or other suitable composition.

Electron beam deposition ("EBD"), such as electron beam physical vapor deposition ("EBPVD") or electron beam directed vapor deposition ("EBDVD"), may be used to deposit the ceramic on the bond coat. EBD utilizes an electron beam gun to melt and vaporize a source material (e.g., gadolinia stabilized zirconia and/or yttria stabilized zirconia) under vacuum to deposit the source material onto the bond coat.

If the ceramic coating includes the gadolinia stabilized zirconia, a specific set of deposition parameters may be used in combination with establishing the desired surface roughness Rz to further facilitate forming a strong bond between the bond coat and the ceramic coating. For example, a particular type of electron beam gun may be used in combination with controlling a chamber pressure and oxygen flow rate within a coating chamber. For instance, the electron beam gun may be an axial electron beam gun (rather than a linear electron beam gun) and the chamber pressure may be about 1 x 10-4 to 1 x 10-3 torr (0.013 - 0.133 pascals). In a further example, the chamber pressure may be about 7 x 10-4 to 1 x 10-3 torr (0.093 - 0.133 pascals).

Prior to applying the ceramic coating onto the bond coat, the articles may be preheated using a predetermined oxygen flow rate. For instance, the oxygen flow rate may be 100 - 700 standard cubic centimeters per minute. The presence of oxygen in combination with a predetermined preheating temperature forms a thermally grown oxide on the bond coat to facilitate bonding to the ceramic coating. After preheating for a predetermined amount of time, the oxygen flow rate may be changed prior to applying the ceramic coating. In one example, the oxygen flow rate may be reduced to the lower end of the given oxygen flow rate range. Reducing the oxygen flow rate provides the benefit of reducing attenuation of the electron beam during the EBD coating process.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the scope of this invention. The scope of legal protection given to this disclosure can only be determined by studying the following claims.

## Claims

1. A method for use in a coating process, comprising:
establishing a desired surface roughness R_{z} of the bond coat, wherein the desired surface roughness R_{z} is an average of surface heights over unit lengths of the bond coat, each of the surface heights extending between a highest surface peak and a lowest surface valley within one of the unit lengths; and
depositing a ceramic coating on a bond coat that is disposed on a substrate.

2. The method as recited in claim 1, further comprising peening the bond coat, for example with cut wire peening media, to establish the desired surface roughness R_{z}.

3. The method as recited in claim 2, further comprising peening the bond coat using a first peening intensity followed by peening the bond coat using a second peening intensity that is lower than the first peening intensity.

4. The method as recited in any preceding claim, further comprising depositing the ceramic coating using electron beam physical vapor deposition.

5. The method as recited in claim 4, further comprising establishing an oxygen flow rate of about 100 - 700 standard cubic centimeters per minute.

6. The method as recited in claim 4 or 5, further comprising depositing the ceramic coating using an axial electron beam gun.

7. The method as recited in claim any preceding, further comprising depositing the bond coat using cathodic arc coating.

8. The method as recited in any preceding claim, wherein the ceramic coating comprises gadolinia stabilized zirconia.

9. A method for use in a coating process, comprising:
depositing a ceramic coating on a bond coat that is disposed on a substrate, the ceramic coating including gadolinia stabilized zirconia, the bond coat including a metal-chromium-aluminum-yttrium layer, where the metal includes at least one of nickel, cobalt, or iron, and the substrate including a nickel alloy; and
establishing a desired surface roughness R_{z} of the bond coat prior to depositing the ceramic coating to control a bonding strength between the bond coat and the ceramic coating, wherein the surface roughness R_{z} is an average of surface heights over unit lengths of the bond coat, each of the surface heights extending between a highest surface peak and a lowest surface valley within one of the unit lengths.

10. The method as recited in claim 8 or 9, further comprising selecting the ceramic coating to further include yttria stabilized zirconia.

11. A method for use in a coating process, comprising:
peening the bond coat using a first peening intensity followed by peening the bond coat using a second peening intensity that is lower than the first peening intensity to establish a desired surface roughness R_{z} of the bond coat prior to depositing the ceramic coating, wherein the surface roughness R_{z} is an average of surface heights over unit lengths of the bond coat, each of the surface heights extending between a highest surface peak and a lowest surface valley within one of the unit lengths; and
depositing a ceramic coating on a bond coat that is disposed on a substrate by using electron beam physical vapor deposition, the ceramic coating including gadolinia stabilized zirconia, the bond coat including a metal-chromium-aluminum-yttrium layer, where the metal includes at least one of nickel, cobalt, or iron, and the substrate including a nickel alloy.

12. The method as recited in any preceding claim, further comprising surface finishing the bond coat using at least one of milling or blasting.

13. The method as recited in any preceding claim, further comprising establishing the desired surface roughness R_{z} to be less than about 0.001 inches (0.0254 millimeters).

14. The method as recited in claim 13, further comprising establishing the desired surface roughness R_{z} to be less than about 0.0003 inches (0.00762 millimeters).

15. The method as recited in claim 14, further comprising establishing the desired surface roughness R_{z} to be about 0.00017 inches (0.004318 millimeters).
